# EUROPEAN PATENT APPLICATION

(11) **EP 0 649 095 A2**
(43) Date of publication of application: **19.04.1995**
(21) Application number: 94307645.5
(22) Date of filing: 18.10.1994
(51) Int. Cl.: G06F 12/08, G11C 16/06

(54) **Nonvolatile storage with high speed data access**

(30) Priority: 19.10.1993 JP 261209/93
(71) Applicant: MATSUSHITA ELECTRIC INDUSTRIAL CO., LTD., Kadoma-shi, Osaka 571 (JP)
(72) Inventor: Nishikawa, Yokinobu, Osaka-shi, Osaka 533 (JP)
(74) Representative: Keltie, David Arthur

(57) **Abstract**

A non-volatile storage that is composed of a plurality of flash memory chips further comprises:
a cache memory having a plurality of entries each storing a data block corresponding to data in the flash memory, a write bit for indicating a write to said data and an erase bit for indicating that data in the flash memory has been erased,
selections means for selecting a data block in a flash memory chip other than a chip to be accessed by a host and corresponding to a cache data block whose write bit is set and whose erase bit is not set,
and erase means for erasing the selected data block.

The non-volatile storage of the present invention has realized high speed data access by reducing the wait time to be spent to start a data rewriting operation after the completion of the erasing operation. The non-volatile storage has further realized improved efficiency of data erasing operations that are not concentrated in time.

## Description

### BACKGROUND OF THE INVENTION

### (1) Field of the Invention

The present invention relates to a nonvolatile storage which is accessed in data blocks by a host by using a flash memory composed of a plurality of flash memory chips capable of erasing data in blocks.

### (2) Description of the Related Art

In recent years, the technology innovation of secondary storage in computer systems has been remarkable, increasing data access speed and data capacity. In particular, compact nonvolatile storage are now in wide use because of their ability of holding data even while the power is off.

For example, the nonvolatile storage disclosed in Japanese Laid-open Patent Application No. 3-259498 is provided with an EEPROM as a nonvolatile memory, and a temporary storage unit having a normal FIFO memory in the previous stage. The EEPROM includes a flash memory whose data can be erased in chips or blocks. When data are written from CPU to the nonvolatile memory, they are at first written in the temporary storage unit and then forwarded to the EEPROM by another circuit, for the purpose of reducing the time period during which CPU is occupied with writing data to the nonvolatile memory. In this case, it is necessary that data in the flash memory be erased before rewriting.

Thus, the conventional nonvolatile storage has to wait for the completion of a data erasing operation to start a data rewriting operation.

It is possible to have cache memory instead of the FIFO memory in order to improve the data access speed. However, when there is a cache miss, data erasing and rewriting procedures are still necessary, which leads to slow data rewriting operations.

### SUMMARY OF THE INVENTION

The first object of the present invention is to provide a nonvolatile storage which has realized high speed data access by reducing the wait time to be spent to start a data rewriting operation after the completion of data erasing operation. The second object of the present invention is to provide a nonvolatile storage with improved efficiency of data erasing operations that are not concentrated at one time.

These objects can be achieved by a nonvolatile storage which is accessed in data blocks by a host by using a flash memory composed of a plurality of flash memory chips capable of erasing data in blocks.

The nonvolatile storage comprises the following units:
a cache memory having a plurality of cache entries, each of the cache entries including data corresponding to data block in the flash memory and a write bit indicating a presence of a write to a data block in the cache entries;
an erase bit holding unit for holding a plurality of erase bits each corresponding to a respective one of the cache entries, the erase bits indicating that data in a data block in the flash memory has bee erased, the data corresponding to the cache entries;
an access target detection unit for detecting a flash memory chip to be accessed by the host;
a selection unit for selecting a data block in the flash memory, the data block corresponding to the flash memory chips other than the detected flash memory chip, and also corresponding to a data block whose write bit is set and whose erase bit is not set among data blocks which have been entered in the cache memory; and
an erase unit for erasing data in more than one data block selected by the selection unit and for setting a corresponding erase bit.

Each of the cache entries may include a block address of a respective data block in the flash memory.

The access target detection unit may include an address holding unit for holding block addresses to be outputted when the nonvolatile storage is accessed by the host.

The selection unit may comprise the following units:
a readout unit for serially reading the block addresses and write bits in the cache entries and the erase bits corresponding to the cache entries;
a comparison unit for comparing high bits of the block address read by the readout unit and high bits of a block address of the address holding unit to determine whether the block addresses belong to a same flash memory chip;
an address holding unit for holding the block address read by the readout unit; and
a determination unit for, when the block addresses have been determined not belong to the same flash memory chip, making the address holding unit hold and output a block address to the erase unit, if a write bit read by the readout unit is set and an erase bit is not set.

The erase unit may erase data in data blocks in accordance with the block address outputted from the address holding unit.

The erase unit may comprise the following units:
a timer unit for generating a timeout when a predetermined erasing time of data blocks in the flash memory chips has been counted;
a command issue unit for issuing an erase command which directs to erase a data block and a block address of data to be erased, to the flash memory chips;
an erasure control unit for starting the command issue unit to the data block selected by the selection unit, making the timer unit start a counting operation, and setting an erase bit corresponding to the selected data block when a timeout is generated.

According to the above construction, the erasure unit performs a data erasing operation to a flash memory chip that is not being accessed by the host. As a result, when there is a cache miss, data in a block in the flash memory which are to be replaced with new ones can be erased in advance, realizing high speed access by the host.

The erase unit may comprise a combination determination unit for determining a plurality of data block whose data to be erased at a same time, among the data blocks selected by the selection unit.

The erase unit may comprise the following units:
a plurality of timer units for generating a timeout when a predetermined erasing time of data blocks in the flash memory chips has been counted;
a command issue unit for issuing an erase command which directs to erase a data block and a block address of data to be erased, to the flash memory chips; and
an erasure control unit for starting the command issue unit to the data block selected by the selection unit, making one of the timer units start a counting operation, and setting an erase bit corresponding to the selected data block when a timeout is generated.

The erasure control unit may start the plurality of timer units by making each of the plurality of timer units correspond to a data block to be erased.

According to the above construction, data in more than one block can be erased at the same time. As a result, it becomes more probable that data to be replaced with new ones be already erased when there is a cache miss.

The nonvolatile storage may further comprise the following units:
a cache control unit for controlling read/write to the cache memory and for exchanging data in the cache memory and data in the flash memory when a cache miss is generated; and
an arbitrator unit for outputting a suspension request to the erase unit when the flash memory chip whose data are to be exchanged is identical to the flash memory chip whose data are being erased by the erase unit.

The erase unit may suspend a data block erasing operation upon receiving the suspension request and restart the data block erasing operation when the suspension request has been released.

The erase unit may comprise the following units:
a timer unit for generating a timeout when a predetermined erasing time of data blocks in the flash memory chips has been counted;
a command issue unit for issuing an erase command which directs to erase a data block and a block address of data to be erased, to the flash memory chips;
a retrieval register having a storage area for retrieving a count value of the timer unit;
an erasure control unit for starting the command issue unit to the data block selected by the selection unit, making the timer unit start a counting operation, retrieving the count value of the timer unit to the retrieval register upon receiving a suspension request from the arbitrator unit, and setting an erase bit corresponding to the selected data block when a timeout is generated.

According to the above construction, if in the same chip, data in a block other than a block whose data is to be replaced by new ones are being erased when there is a cache miss, the data erasing operation is suspended. As a result, data access by the host can be speed up.

The arbitrator unit may output the suspension request unless a copy back operation is in process for exchanging data of entries by the cache control unit.

The combination determination unit may determine a certain number of block, the number being an integer closest to Te/Tcb. The "Te" indicates the block erase time and the "Tcb" indicates a time required for copying back data in one block from an entry to the flash memory by the cache control unit.

According to the above construction, when data in a block are in a copy back operation, data in other blocks can be erased at the same time. As a result, timely data erasing operations can be conducted.

### BRIEF DESCRIPTION OF THE DRAWINGS

These and other objects, advantages and features of the invention will become apparent from the following description thereof taken in conjunction with the accompanying drawings which illustrate a specific embodiment of the invention. In the drawings:-
FIG. 1 is a block diagram showing the construction of the nonvolatile storage of the first embodiment.
FIG. 2 is the bit configuration of the flash memory array 1 having 24 bit address of the first embodiment.
FIG. 3 is a block diagram showing the construction of the block address register and the address generation unit of the first embodiment.
FIG. 4 is a block diagram showing the detailed construction of the block selection unit of the first embodiment.
FIG. 5 is a block diagram showing the detailed construction of the erasure control unit of the first embodiment.
FIG. 6 is a flowchart depicting the process of a cache read miss in the first embodiment.
FIG. 7 is a flowchart depicting the process of a cache write miss in the firs embodiment.
FIG. 8 is a block diagram showing the construction of the nonvolatile storage in the second embodiment.
FIG. 9 is a block diagram showing the construction of the erasure control unit and the erase state administration unit in the second embodiment.
FIG. 10 is a flowchart depicting the process of a cache read miss in the second embodiment.
FIG. 11 is a flowchart depicting the process of a cache write miss in the second embodiment.
FIG. 12 is a block diagram showing the construction of the nonvolatile storage of the third embodiment.
FIG. 13 is a block diagram mainly showing the detailed construction of the erasure control unit 125.

### DESCRIPTION OF THE PREFERRED EMBODIMENTS

### <Embodiment 1>

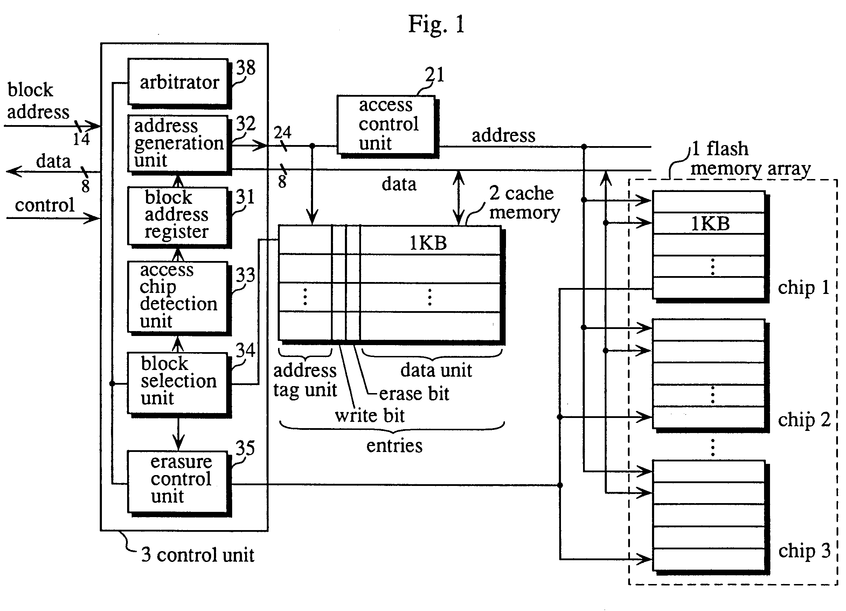

FIG. 1 is a block diagram showing the construction of the nonvolatile storage of this embodiment. The nonvolatile storage is composed of a flash memory array 1, a cache memory 2, an access control unit 21, and a control unit 3. The operations for reading/writing data are carried out through an unillustrated host computer (hereinafter CPU).

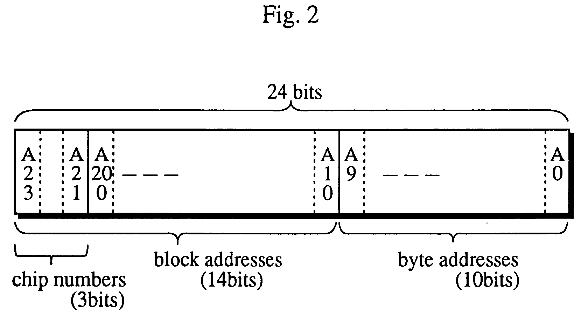

The flash memory array 1 is composed of flash memory chips whose data can be erased in block units. In this embodiment, the flash memory array 1 has a 16Mbyte storage capacity, a lkbyte block size, an 8 bit data width, and a 24 bit address width. The bit configuration of the 24 bit address is shown in FIG. 2. As shown in FIG. 2, the highest 3 bits indicate the addresses of the eight chips (hereinafter chip number). The highest 14 bits indicate the addresses of the blocks, and the lowest 10 bits indicate the addresses of the bytes in the blocks.

The flash memory chips used in this embodiment, which are commercially available, has a 2Mbyte capacity and are capable of erasing data in 1kbyte block units, reading/writing data in byte units. The data erasing and writing operations (program), reading/writing data in byte units are carried out by a series of sequence including an external command input and data input. For example, a data erasing operation is carried out by (1) inputting an erase command, (2) inputting a block address, and (3) waiting for a predetermined data erasing time to elapse. A data writing operation is carried out by (1) inputting a program command, (2) inputting an address and data for 1 byte, (3) repeating the operation of (2) until reaching one data block.

In the flash memory chip used in this embodiment, a reading time for 1 byte data is 100nS, a writing time for 1 byte data in erased data blocks is 3µS, an erasing time for 1 block data is 9mS. In this case, a reading time for 1 block data is 100µS and a writing time for erased 1 block data is 3mS.

The cache memory 2, which works as a cache of the flash memory array 1, includes an area for storing 16 entries each composed of a data field, an address tag field, a write bit, and an erase bit. Each data field stores data for 1 block of the flash memory. Each address tag unit stores 14-bit block address and indicates the data block stored in the data field of the same entry. The write bit indicates that the data block in the data field of the same entry does not coincide with the corresponding data block in the flash memory, and that it is necessary to copy the data back to the flash memory. The copy back means to copy the data in the data field to the data block of the flash memory indicated by the address tag unit of the same entry. The on state of the erase bit indicates that the data block in the flash memory corresponding to the data field has already been erased. This means that the copy back of data to the flash memory is possible. A reading/writing time for 1 byte data to the cache memory 2 is 50nS, which means that a reading/writing time for 1 block data is 50µS.

The access control unit 21 judges whether there is a cache hit or cache miss, and controls a data reading/writing operation to the cache memory 2 when there is a cache hit. Otherwise, the access control unit 21 controls a data reading/writing operation to the flash memory array 1 and copy back and update of data to the cache memory 2 in accordance with the instruction of an arbitrator 38. The update means to newly copy one data block of the flash memory array 1 to the cache memory 2. The access control unit 21 turns off the writing flag of the entry upon finishing the update, and turns it on when a data writing from the CPU to the data field has been finished. In this embodiment, the copy back method and LRU method, which are both well known, are employed respectively as a method of controlling the cache memory 2 and a method of exchanging the entries.

The control unit 3, which controls the flash memory array 1 and the cache memory 2, and the data transfer to/from the CPU, is composed of a block address register 31, an address generation unit 32, an access chip detection unit 33, a block selection unit 34, an erasure control unit 35, and an arbitrator 38.

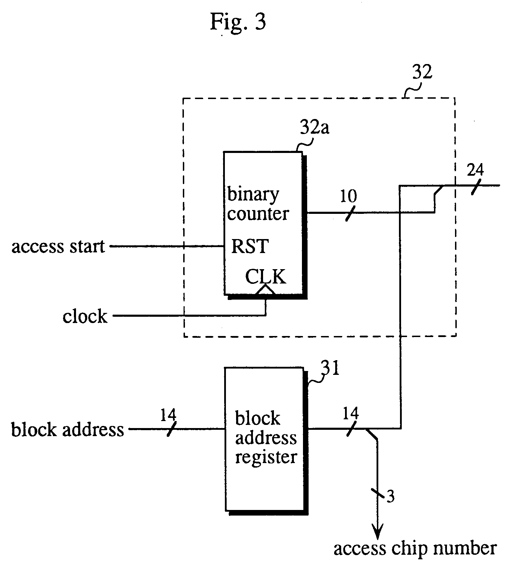

The block address register 31 stores block addresses sent from the CPU. To be more specific, the block address register 31 is composed of a 14-bit register as shown in FIG. 3, which has an address line for receiving block addresses sent from the CPU and a control signal for informing the access start from the CPU.

The address generation unit 32 generates 24-bit addresses by adding 10-bit byte addresses to the 14-bit block address of the block address resister 31 in accordance with the instruction of the access control unit 21. To be more specific, as shown in FIG. 3, the address generation unit 32 includes a binary counter 32a for generating 10-bit byte address. The binary counter 32a receives the control signal informing an access start and a clock for generating byte addresses, thereby generating addresses consecutively.

The access chip detection unit 33 detects a flash chip including a data block which the CPU is trying to access, from the contents of the block address register 31. To be more specific, the access chip detection unit 33 receives the higher 3 bits of the block address resister 31, which indicate the flash memory chip number, and either directly outputs the higher 3 bits as a chip number or outputs after decoding them. In this embodiment, the higher 3 bits are outputted directly.

The block selection unit 34 selects an entry whose write bit is in the on state and whose erase bit is in the off state from among the entries which store the data blocks belonging to the flash memory chip other than the one detected by the access chip detection unit 33. Then, the block selection unit 34 outputs the block address in the selected entry as an erase block No.

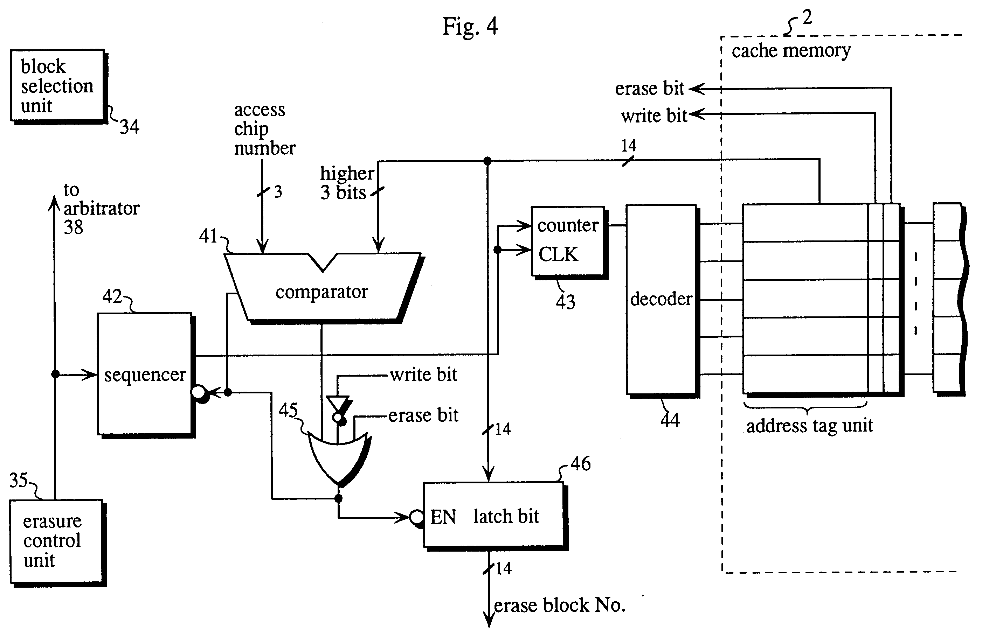

FIG. 4 shows a detailed configuration of the block selection unit 34.

The block selection unit 34 is composed of a comparator 41, a sequencer 42, a counter 43, a decoder 44, an OR gate 45, a NOT gate, and a latch circuit 46.

The counter 43 counts the entry numbers from 0 to 15 under the control of the sequencer 42.

The decoder 44 decodes the entry numbers to select corresponding entries. The selected entries have their address tag units, write bits, and erase bits read out.

The comparator 41 compares the higher 3 bits of each of the read address tag units and the chip number of the access chip detection unit 33 to determine whether they are equal or not.

The OR gate 45 outputs "0" when the entry read from the cache memory 2 belongs to the flash memory chip other than the chips detected by the access chip detection unit 33, and when its write bit is in the on state and the erase bit is in the off state.

The latch circuit 46 transparently outputs the higher 14 bits of the address tag unit as an erase block number, when the OR gate 45 is outputting "0". When the output of the OR gate 45 is changed to "1", the latch circuit 46 holds and outputs the 14 bits. The output indicates the block number corresponding to the data to be erased.

The erasure control unit 35 erases the data in the block selected by the block selection unit 34, and then turns on the erase bit corresponding to the cache memory 2. When data to be copied back is directed by the arbitrator 38, the data in the block is deleted.

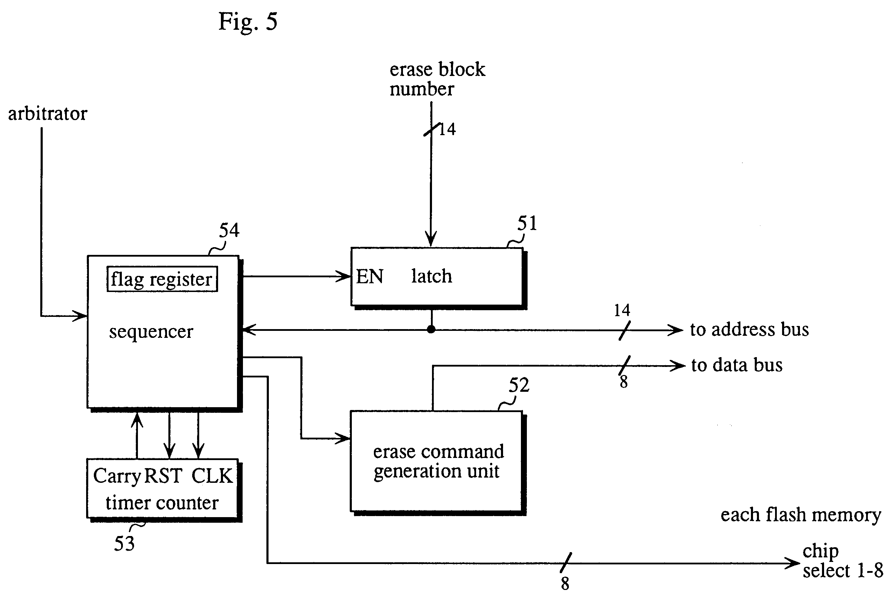

FIG. 5 shows a detailed configuration of the erasure control unit 35. The erasure control unit 35 is composed of a latch circuit 51, an erase command generation unit 52, a timer counter 53, and a sequencer 54.

The latch circuit 51 holds the erase block number sent from the block selection unit 34.

The erase command generation unit 52 issues an erase command in accordance with the instruction of the sequencer 54.

The timer counter 53 starts a counting operation in accordance with the instruction of the sequencer 54 and outputs a carry bit after the erase time (9mS) has elapsed.

The sequencer 54, which includes a flag register 54a for holding a flag during an erasing operation for each flash memory chip, controls an erasing sequence consisting of (1) issuing the erase command, (2) issuing a block address, and (3) waiting for an erasing time. To be more specific, (1) the sequencer 54 makes effective the chip selection signal for the corresponding flash memory chip by decoding the higher 3 bits of the latch circuit 51, and makes the erase command generation unit 52 issue an erase command. Then, (2) the sequencer 54 outputs the chip selection signal and makes the latch circuit 51 issue a block address. At the same time, the sequencer 54 starts the timer counter 53, and sets an erasing operation flag corresponding to the chip number indicated by the higher 3 bits. Then, (3) the flash memory chip selected by the chip selection signal starts a data erasing operation, so that the sequencer 54 waits for a carry (time out) to be outputted from the timer counter 53. After the carry has been outputted, the sequencer 54 resets the erasing operation flag and turns on the erase bit of the entry which holds the corresponding block address in the cache memory 2.

The arbitrator 38 arbitrates between an access operation of the access control unit 21 to the flash memory array 1 and an erasing operation by the erasure control unit 35. To be more specific, when there is no read miss or write miss in an access by the CPU, the arbitrator 38 makes the access operation and the data erasing operation operate independently of each other without any restrictions. In contrast, when there is a read miss or write miss, if data in the block to be copied back or update is being erased by the erasure control unit 35, the copy back or update is started upon the completion of the erasing operation.

### (Operations)

The following is an operational description of the nonvolatile storage of this embodiment.

The CPU sends a 14-bit block address and a data read/write control signal to the control unit 3 of the nonvolatile storage, to request to read or write data. The control unit 3 outputs the data read/write control signal sent from the CPU to the access control unit 21, and sets a 14-bit block address to the block address register 31, and, at the same time, outputs the 14-bit block address to the access control unit 21. The access control unit 21 determines whether there has been a cache hit or cache miss by comparing the block address sent from the block address register 31 and the address tag unit of the cache memory 2, then informs the arbitrator 38 of the results.

The arbitrator 38 operates as follows in accordance with the results.

### (1) when there is a cache hit

Since the data to be accessed exists in the cache memory 2, the access control unit 21 directly reads/writes data from/to the cache memory 2. Consequently, the data erasing operation of the erasure control unit 35 does not contend with an cache access of the access control unit 21, so that the arbitrator 38 lets the data erasing operation independent.

The data erasing operation of the flash memory array 1 by the erasure control unit 35 is carried out as follows.

The access chip detection unit 33 detects the corresponding flash memory chip from the contents of the block address register 31. The block selection unit 34 selects the data block which corresponds to the entry whose write bit is in the on state and whose erase bit is in the off state from among entries storing data blocks belonging to the flash memory chip other than the chip detected by the access chip detection unit 33. The erasure control unit 35 provides the data block selected by the block selection unit 34 with a data erasing sequence, thereby starting to erase the data in the corresponding block. The erasure control unit 35 further turns the erase operation flag on. On completing the data erasing operation, the erasure control unit 35 turns the erase operation flag off, and turns the erase bit of the address tag unit on.

As described hereinbefore, when there is no cache miss, no copy back to the flash memory array 1 or no update of the cache entry is necessary, so that there is no data read/write operation from/to the flash memory array 1 by the access control unit 21. Consequently, there is no contention with the data erasing operation of the erasure control unit 35, and the erasure control unit 35 can erase the data block of the flash memory array 1 which corresponds to the entry independent of a data read/write operation from the CPU to the cache memory.

### (2) when there is a cache read miss

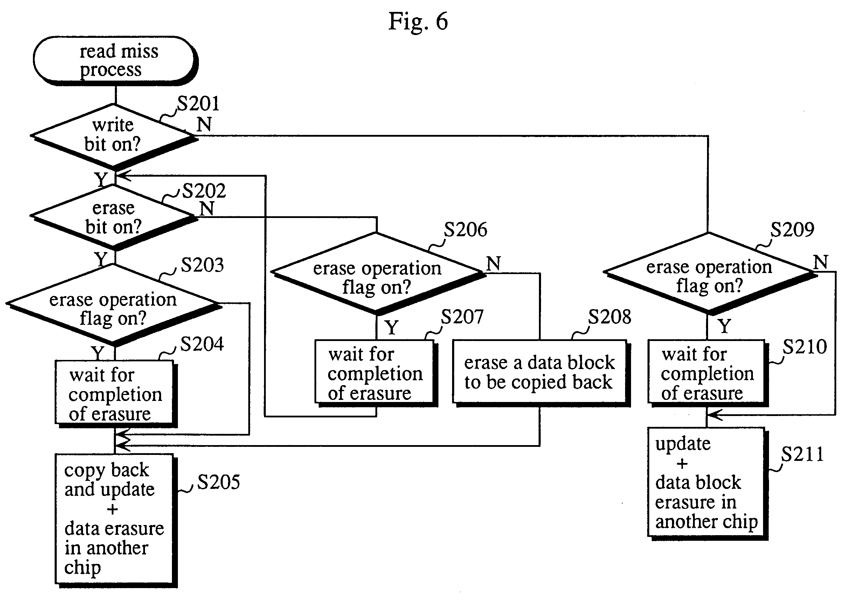

The operation of the arbitrator 38 is shown in the flowchart of FIG. 6. Since the cache memory 2 has no data to be accessed from the CPU, it is necessary to copy back and update one of the entries. There is a possibility that the operation contends with the data erasing operation of the erasure control unit 35, so that the access control unit 21 informs the arbitrator 38 of the occurrence of a cache read miss.

The arbitrator 38 refers to the write bit and the erase bit of the entry to be replaced which is determined by the access control unit 21 based on the LRU method. The arbitrator 38 determines whether (2a) the write bit is in the on state and the erase bit is in the off state, (2b) the write bit and the erase bit are both in the on state, or (2c) the write bit is in the off state (Steps 201 and 202).

### (2a) When the write bit is in the on state and the erase bit is in the off state

Since the write bit of the entry to be replaced is in the on state (Step 201: yes), it is necessary to copy back the data block in the entry to the flash memory array 1. The erase bit is in the off state (Step 202: no), so that the corresponding data block in the flash memory array 1 is being erased by the erasure control unit 35 or has not been erased yet. The arbitrator 38 refers to the flag register 54a in the erasure control unit 35. If the erase operation flag of the flash memory chip to be copied back is in the on state (Step 206: yes), the arbitrator 38 waits for the erasing operation to be completed (Step 207) and then restarts from the checking of the erase bit (Step 202). On the other hand, if the erase operation flag is in the off state (Step 206: no), then this means the data erasing operation has not been started. Consequently, the arbitrator 38 makes the erasure control unit 35 erase the data in the block (Step 208). Upon completing the data erasing operation, the arbitrator 38 makes the access control unit 21 start a copy back process, and upon the completion of the copy back operation, the data to be accessed is updated to the entry and also makes the access control unit 21 output the data to the CPU.

Independent of the copy back or the update, the erasure control unit 35 further eases a data block in another chip in the flash memory array 1 (Step 205). The following is an explanation of the data erasing operation.

The access chip detection unit 33 in the control unit 3 detects the flash memory chip to be accessed in a data read process of the flash memory array 1 from the contents of the block address register 31. In other words, the access chip detection unit 33 extracts the higher 3 bits in the 14 bits set in the block address register 31, thereby detecting which of the 8 flash memory chips the data block belongs to. The block selection unit 34 selects the data block corresponding to the entry whose write bit is in the on state from among the entries which store the data blocks belonging to the flash memory chips other than the chip detected by the access chip detection unit 33. The erasure control unit 35 sends a block address and an erase control signal to the data block selected by the block selection unit 34, thereby erasing the data block of the flash memory array 1. On completing the data erasing operation, the erase bit of the entry to be erased in the cache memory 2 is put in the on state.

### (2b) When the write bit and the erase bit are both in the on state

Since the write bit of the entry to be replaced is in the on state (Step 201: yes), it is necessary to copy back the data in the cache memory 2 to the flash memory array 1. Furthermore, the erase bit is also in the on state (Step 202: yes), which means that the corresponding data block in the flash memory array 1 has already been erased. The arbitrator 38 refers to the flag register 54a in the erasure control unit 35, and makes the access control unit 21 start a copy back operation immediately if the erase operation flag of the flash memory chip, which is to be copied back is in the off state (step 203:no). If the erase operation flag is in the on state (step 203:yes), the arbitrator 38 waits for the completion of the data erasing operation for another data block in the flash memory chip to be accessed (step 204), and makes the access control unit 21 start a copy back operation. Upon completing the copy back operation, data to be written in the entry is updated, and at the same time, is outputted to the CPU (step 205). In step 205, the data erasing operation by the erasure control unit 35 is also carried out.

### (2c) when the write bit is in the off state

Since the write bit is in the off state (Step 201:no), it is unnecessary to copy back data; however, it is necessary to update data block in the entry to be replaced. The arbitrator 38 refers to the flag register 54a in the erasure control unit 35, and makes the access control unit 21 start a copy back operation immediately when the erasure operation flag of the flash memory chip to be accessed is in the off state (step 209:no). If the erasure operation flag is in the on state (step 209:yes), then this means the data block in the flash memory chip to be accessed is being erased. The arbitrator 38 waits for the completion of the data erasing operation (step 210), and then carries out a cache entry update while controlling a read out of data to the CPU (step 211). In step 211, the data erasing operation by the erasure control unit 35 is also carried out.

### (3) when there is a cache write miss

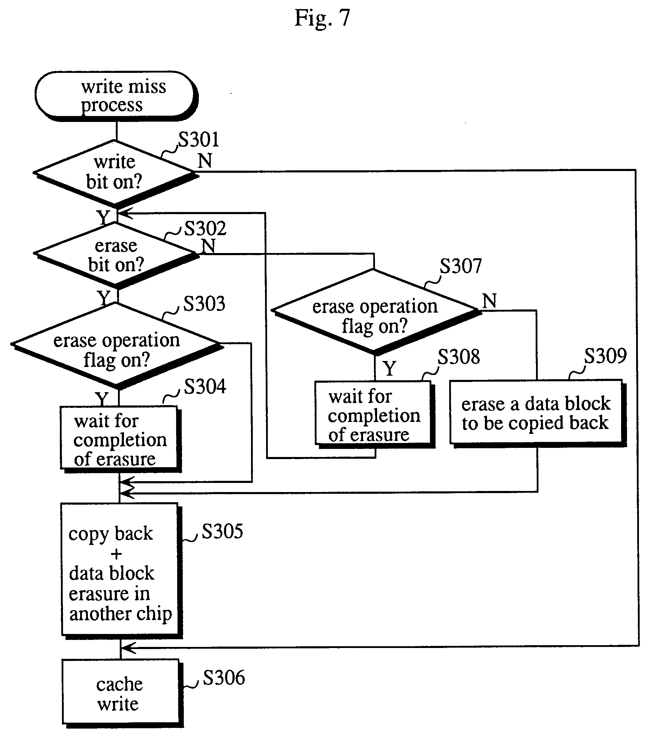

FIG. 7 is a flowchart showing the operation of the arbitrator 38. Upon being informed of the occurrence of a cache write miss from the access control unit 21, the arbitrator 38 refers to the write bit and the erase bit of the entry to be replaced and determines whether (3a) the write bit is in the on state and the erase bit is in the off state, (3b) the write bit and the erase bit are both in the on state, or (3c) the write bit is in the off state (Steps 301 and 302).

### (3a) When the write bit is in the on state and the erase bit is in the off state

Since the write bit of the entry to be replaced is in the on state (Step 301: yes), it is necessary to copy back the data block in the entry to the flash memory array 1. The erase bit is in the off state (Step 302: no), so that the corresponding data block in the flash memory array 1 is being erased or has not been erased yet. The arbitrator 38 refers to the erase operation flag in the erasure control unit 35. If the erase operation flag is in the on state (Step 307: yes), the arbitrator 38 waits for the data erasing operation to be completed (Step 308) and then restarts from the checking of the erase bit (Step 302). On the other hand, if the erase operation flag is in the off state (Step 307: no), then this means the data erasing operation for the data block has not been started. Consequently, the arbitrator 38 makes the erasure control unit 35 erase the data (Step 309). Upon completing the data erasing operation, the arbitrator 38 makes the access control unit 21 start a copy back process (step 305). Upon the completion of the copy back operation, the arbitrator 38 writes data from the CPU to the corresponding entry, and resets the write bit to the on state and erase bit to the off state (Step 306).

In steps 305 and 306, the erasure control unit 35 erases a data block in another chip in the flash memory array 1.

### (3b) when the write bit and the erase bit are both in the on state

Since the write bit of the entry to be replaced is in the on state (Step 301: yes), it is necessary to copy back the data in the cache memory 2 to the flash memory array 1. Furthermore, the erase bit is also in the on state (Step 302: yes), which means that the corresponding data block in the flash memory array 1 has already been erased. The arbitrator 38 refers to the flag register 54a in the erasure control unit 35, and makes the access control unit 21 start a copy back operation immediately if the erase operation flag of the flash memory chip, which is to be copied back is in the off state (step 303:no). If the erase operation flag is in the on state (step 303:yes), the arbitrator 38 waits for the completion of the data erasing operation (step 304), and makes the access control unit 21 start a copy back operation.

Upon completing the copy back operation (step 305), the arbitrator 38 writes a data block to be written in the corresponding entry of the cache memory 2 from the CPU. Upon the completion of the data writing operation, the write bit is put in the on state and the erase bit is put in the off state (step 306). In steps 305 and 306, the erasure control unit 35 also controls data blocks in another chip.

### (3c) when the write bit is in the off state

When the write bit is in the off state, it is unnecessary for an entry to be replaced to perform a copy back. Consequently, the arbitrator 38 makes the access control unit 21 write a data block to be written from the CPU into the entry to be replaced in the cache memory 2. Upon the completion of the data writing operation, the write bit is put in the on state, and the erase bit is put in the off state (step 306).

According to these operations, a process responding to a request for reading/writing data from/to the CPU made by the access control unit 21 and an erasing operation of data in the flash memory array by the erasure control unit 35 are performed concurrently. This improves the speed of accessing CPU even when there is a cache miss.

### <Embodiment 2>

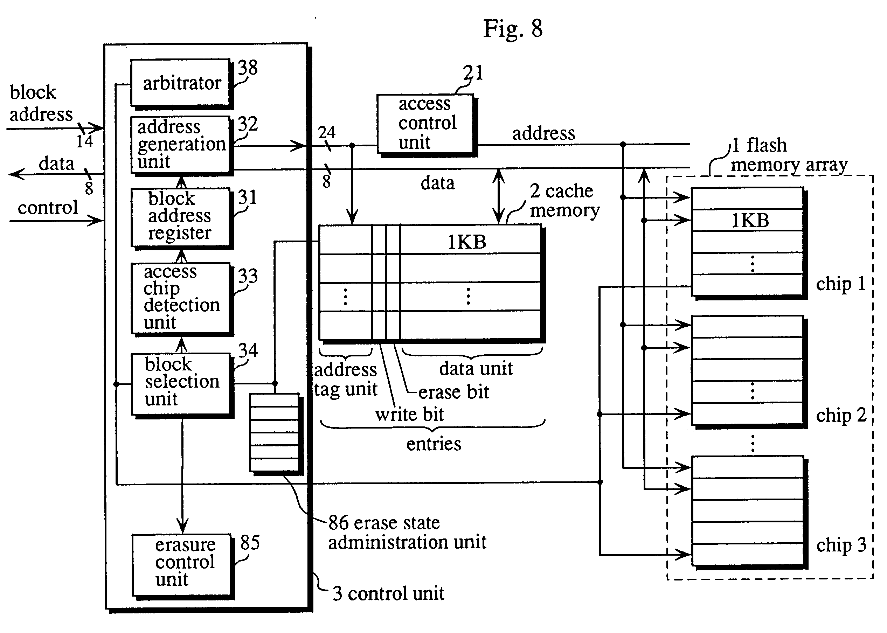

FIG. 8 is a block diagram showing the construction of the nonvolatile storage of this embodiment in which like components are labeled with like reference numerals with respect to the first embodiment, and the description of these components is not repeated. The nonvolatile storage of this embodiment is different from that of the first embodiment in that in the control unit 3, the erasure control unit 35 and the arbitrator 38 provided in the first embodiment are replaced by the erasure control unit 85 and the arbitrator 88 respectively, and the erase state administration unit 86 is additionally provided.

The flash memory chips used in the flash memory array 1 are commercially available just like those used in the first embodiment, and its function of suspending a data erasing operation is used. To be more specific, the flash memory chips of this embodiment suspend a data erasing operation if received a read command or a write command after (1) an erase command and (2) a block address before the elapse of the erase time (9mS). For example, if the flash memory chips receive another command when 4mS has passed, the data erasing operation is suspended. The data erasing operation is restarted when the flash memory chips receive (1) an erase command and (2) a block address after the completion of the command. The data erasing operation is completed at the time point that the remaining time (5mS) has elapsed.

In FIG. 8, the arbitrator 88 has an additional function compared with the arbitrator 38 of the first embodiment. In the occurrence of a contention between an erasing operation and a copy back or an update, the arbitrator 88 suspends the data erasing operation by sending an erasure suspension request to the erasure control unit 85, then makes the access control unit 21 copy back or update.

The erasure control unit 85, which includes the same function as the erasure control unit 35 of the first embodiment, has the following additional function.

When the erasure control unit 85 receives an erasure suspension request from the arbitrator 88 during a data erasing operation, the erasure control unit 85 suspends the data erasing operation and stores the data erasing elapse time at the point to the erase state administration unit 86 to suspend the data erasing operation. After this, when the erasure suspension request is released, the erasure control unit refers to the erase state administration unit 86 and to restart the data erasing operation.

The erase state administration unit 86 has an area to store erase elapse time per entry when there is a suspension of a data erasing operation.

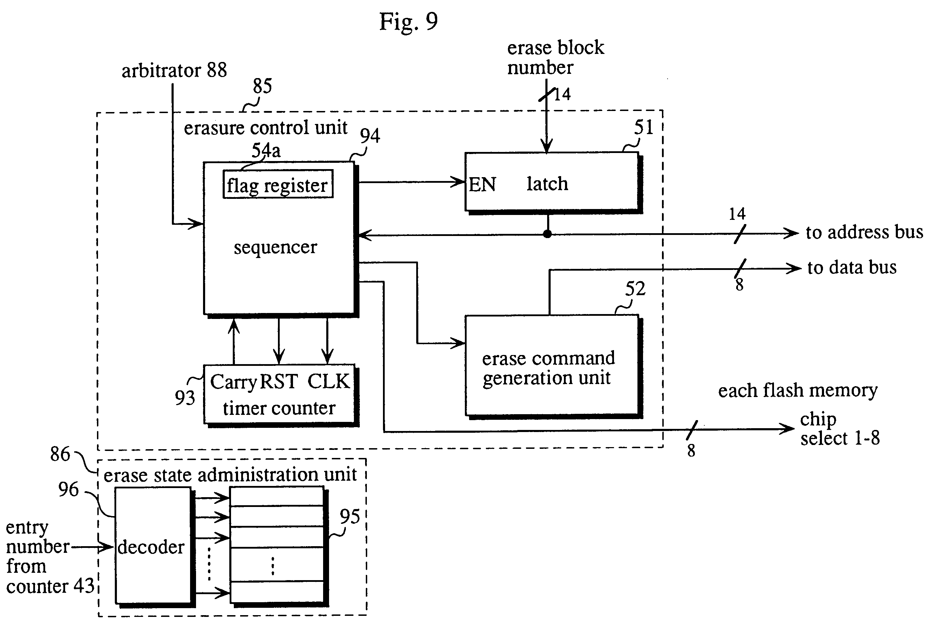

FIG. 9 is a block diagram showing the detailed construction of the erasure control unit 85 and the erase state administration unit 86. The erasure control unit 85 is composed of a latch circuit 51, an erase command generation unit 52, a timer counter 93, and a sequencer 94. The latch circuit 51 and the erase command generation unit 52 are equal to their equivalents in FIG. 5, so that they are not explained again.

Compared with the timer counter 53 shown in FIG. 5, the timer counter 93 has an additional function of loading and storing count values. To be more specific, the timer counter 93 stores, under control of the sequencer 94, a count value (erase elapse time) on the restarting point of the data erasing operation to the erase state administration unit 86. Then the timer counter 93 loads the count value from the erase state administration unit 86 at the beginning of the restarting operation.

Compared with the sequencer 54 shown in FIG. 5, the sequencer 94 has an additional function of performing a suspension process upon receiving an erasure suspension request from the arbitrator 88 and a restart process when the erasure suspension request has been released. To be more specific, the sequencer 94 stores the count value of the timer counter 93 to the erase state administration unit 86 upon receiving an erasure suspension request. The flash memory chip in an ease operation suspends the data erasing operation by making the access control unit 21 issue a read command (in the case of entry update) or a write command (in the case of copy back).
When the erasure suspension request has been released, the sequencer 94 makes the erase command generation unit 52 issue (1) an erase command and also makes the latch circuit 51 issue a block address, and at the same time restarts counting by loading a count value from the erase state administration unit 86 to the timer counter 93. When the timer counter has finished to count the remaining time, the data erasing operation is completed.

The erase state administration unit 86 is composed of a register file 95 and a decoder 96.

The register file 95 consists of 16 registers each corresponding to the entry of the cache memory 2. Under the control of the sequencer 94, each register is written the count value of the timer counter 93 therein when a data erasing operation is suspended and is read it when the data erasing operation is restarted.

The decoder 96 decodes the entry number outputted from the counter 43 shown in FIG. 4 when the count value has been read/written from/to the register file 95. Then the decoder 96 selects the register corresponding to the entry number.

### <Operations>

The operations of the nonvolatile storage of this embodiment which is constructed as described above are as follows.

### (1) when there is a cache hit

This case is not described because it is equal to the first embodiment.

### (2) when there is a cache read miss

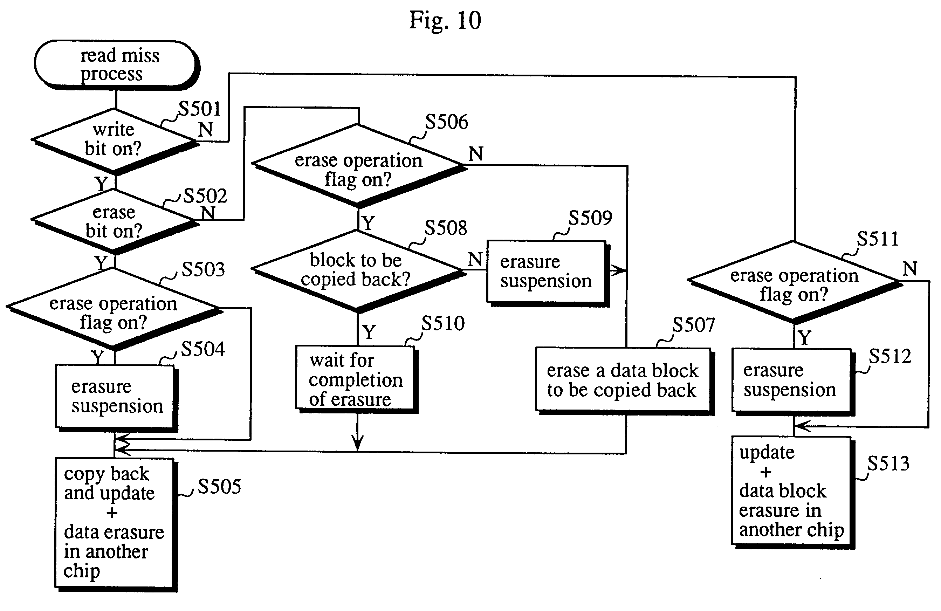

FIG. 10 is a flowchart showing the operation of the arbitrator 88 in this case. The flowchart is equal to the flowchart shown in FIG. 6 except for Steps 504, 508, 509, and 512. The description for the common steps are not repeated. (2a) When the write bit is in the on state and the erase bit is in the off state (step 501:yes, step 502:no)

The arbitrator 88 refers to the flag register 54a in the erasure control unit 85, and, when the erase operation flag in a flash memory chip to be accessed is in the off state (step 506:no), makes the access control unit 21 erase a data block to be copied back in the same manner as the first embodiment (step 507), thereby proceeding to step 505. When the erase operation flag is in the on state (step 506:yes), the arbitrator 88 determines whether the data block which is being erased by the erasure control unit 85 and a data block which the access control unit 21 is going to be copied back match each other or not. If they do not match (step 508:no), this means that the data block which is being erased is not a target for replacing. As a result, the arbitrator 88 sends an erasure suspension request to the erasure control unit 85 to suspend the data erasing operation (step 509), then to erase the target data block to be copied back (step 507). In contrast, if they match (step 508:yes), the arbitrator 88 waits for the completion of the data erasing operation (step 510), and proceeds to the step 505. In step 505, a data block erasing operation in another chip is carried out concurrently with the copy back and the update in the same manner as the step 505 in the first embodiment. Here, the data block in the flash memory array 1 whose data erasing operation has been suspended is re-selected by the block selection unit 34 because the erase bit is not in the on state. Upon selecting the data block, the erasure control unit 85 restarts the data erasing operation.

### (2b) When the write bit and the erase bit are both in the on state (step 501:yes, step 502:yes)

The arbitrator 88 refers to the erase operation flag of the erasure control unit 85. If the flag is in the on state (step 503:yes), this means the data block which is being erased is another data block in the chip which is a target to be accessed. As a result, the arbitrator 88 makes the erasure control unit 85 suspend the data erasing operation by sending an erasure suspension request (step 504). Then, as explained in the above (2a), a data block erasing operation in another chip is carried out by the erasure control unit 85 concurrently with the copy back and the update (step 505).

### (2c) when the write bit of the entry to be replaced is in the off state (step 501:no)

The arbitrator 88 refers to the erase operation flag of the erasure control unit 85 (step 511). Unlike in the first embodiment, when the erase operation flag is in the on state, the arbitrator 88 makes the erasure control unit 85 suspend the data erasing operation by sending an erasure suspension request (step 504). Hereinafter, the same operations as in the step 211 in the first embodiment are carried out, so that the explanation is omitted.

### (3) when there is a cache write miss

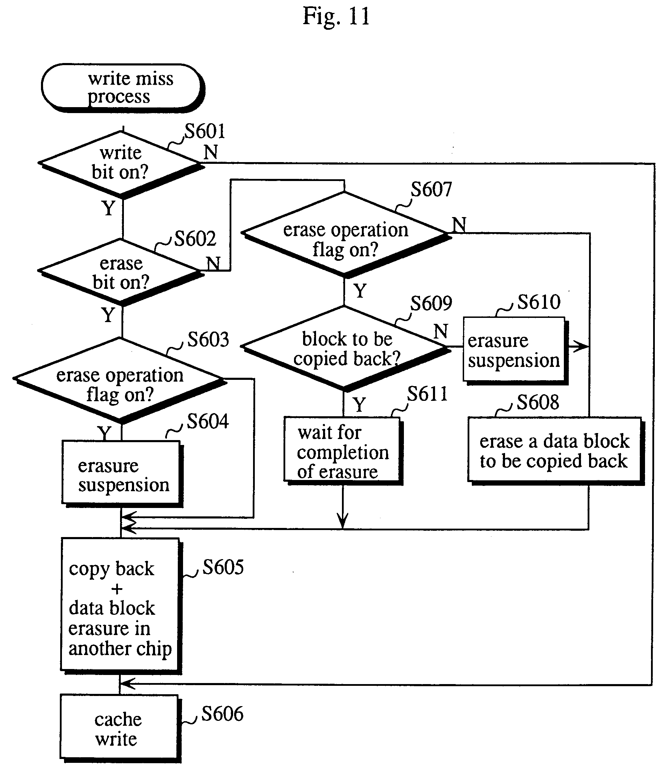

The operation of the arbitrator 88 in this case is shown in the flowchart in FIG. 11. This flowchart is the same as the flowchart in FIG. 7 of the first embodiment except the step 604 is provided instead of step 304, and the steps 609 and 610 are additionally provided. The common operations are not described.

### (3a) When the write bit is on and the erase bit is off (step 601:yes, step 602:no)

The arbitrator 88 refers to the flag register 54a in the erasure control unit 85. When the erase operation flag of the chip to be accessed is in the off state (step 607:no), the arbitrator 88 makes the access control unit 21 erase a data block to be copied back in the same manner as the first embodiment, and proceeds to the step 605. When the erase operation flag is in the on state (step 607:yes), the arbitrator 88 determines whether the data block which is being erased by the erasure control unit 85 and the data block which the access control unit 21 is going to copy back match each other. When they does not match (step 609:no), this means that the data block which is being erased is not a data block to be replaced. As a result, the arbitrator 88 makes the erasure control unit 85 suspend the data erasing operation by sending an erasure suspension request (step 610) and then suspend the data block to be copied back (step 608). In contrast, when they match each other (step 609: yes), the arbitrator 88 waits for the completion of the data erasing operation (step 611), and proceeds to steps 605 and 606. A data erasing operation in another chip is carried out by the erasure control unit 85 concurrently with the copy back and the update. After this, the access control unit 21 makes a cache write (step 606). At this point, the erase bit of the block in the flash memory array 1 whose data erasing operation has been suspended is not in the on state. Consequently, it is re-selected by the block selection unit 34. Upon selecting the data block, the erasure control unit 85 restarts the data erasing operation.

### (3b) when the write bit and the erasure bit are both in the on state (step 601:yes, step 602:yes)

The arbitrator 88 refers to the erasure operation flag of the erasure control unit 85. When the erasure operation flag is in the on state (step 603:yes), this means that the data block which is being erased is another data block in the chip to be accessed. Consequently, the arbitrator 88 makes the erasure control unit 85 suspends the data erasing operation by sending an erasure suspension request (step 604). A data erasing operation in another chip is carried out by the erasure control unit 85 concurrently with the copy back and the update as explained in the above (a) (step 605). After this, the access control unit 21 makes a cache write (step 606).

### (3c) When the write bit of the entry to be replaced is in the off state (step 601:no)

In this case, there is no need of copying back for the entry to be replaced. Consequently, the arbitrator 88 makes the access control unit 21 write a data block sent from the CPU that is to be written into the entry in the cache memory 2 to be replaced. After the writing, the write bit and the erase bit of the entry are put to the on state and off state respectively (step 606).

According to these operations, a process responding to a request for reading/writing data from/to the CPU made by the access control unit 21 and an erasing operation of data in the flash memory array 1 by the erasure control unit 35 are performed concurrently. This improves the speed of accessing CPU even when there is a cache miss.

Furthermore, the data erasing operation can be suspended, and as a result, overhead, which is cased while a completion of a data erasing operation is waited can be eliminated.

In addition, when a data block whose erasion has been once suspended is re-erased, the data erasing operation can restart from the point where the operation is suspended without restarting from the very beginning, so that the time required for the data erasing operation can be minimized.

### <Embodiment 3>

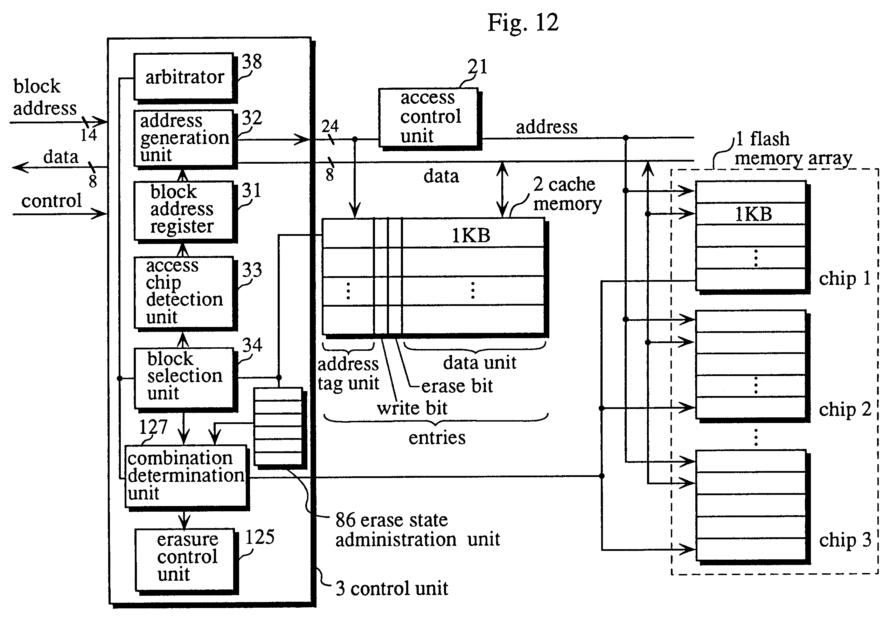

FIG. 12 is a block diagram showing the construction of the nonvolatile storage of this embodiment in which like components are labeled with like reference numerals with respect to the second embodiment, and the description of these components is not repeated. The nonvolatile storage of this embodiment is different from that of the second embodiment in that in the control unit 3, the erasure control unit 85 and the arbitrator 88 provided in the second embodiment are replaced by the erasure control unit 125 and the arbitrator unit 128 respectively, and the combination determination unit 127 is additionally provided.

The combination determination unit 127 selects at most three data blocks to be erased at the same time from among blocks selected by the block selection unit 34, based on the information of the erase state administration unit 86. To be more specific, the combination determination unit 127 receives all the erasable data block numbers outputted from the block selection unit 34, refers to the erase elapse time of the register file 95 in the erase state administration unit 8, and selects three data blocks having shortest erase elapse time, thereby outputting them to the erasure control unit 125.

The erasure control unit 125 has, in addition to the same function as the erasure control unit 85, an additional function of concurrently erasing three data blocks determined by the combination determination unit 127.

The arbitrator 128 has an additional function of restricting the operation of the erasure control unit 125 besides the same function as the arbitrator 88 to arbitrate the contention between the access control unit 21 and the erasure control unit 125. To be more specific, the arbitrator 128 outputs an erasure suspension request to the erasure control unit 125 when there is no copy back, releases the suspension request when a copy back is started by the access control unit 21, and outputs the suspension request when the copy back is over. In other words, the arbitrator 128 makes the erasure control unit 125 a data erasing operation only when the access control unit 21 is in an copying back operation. The reason for this restriction is that in the flash memory array of this embodiment, copy back time for one block is 3mS and data erase time is 9mS, so that the copy back and the data erasing operation can be balanced by erasing three data blocks at the same time.

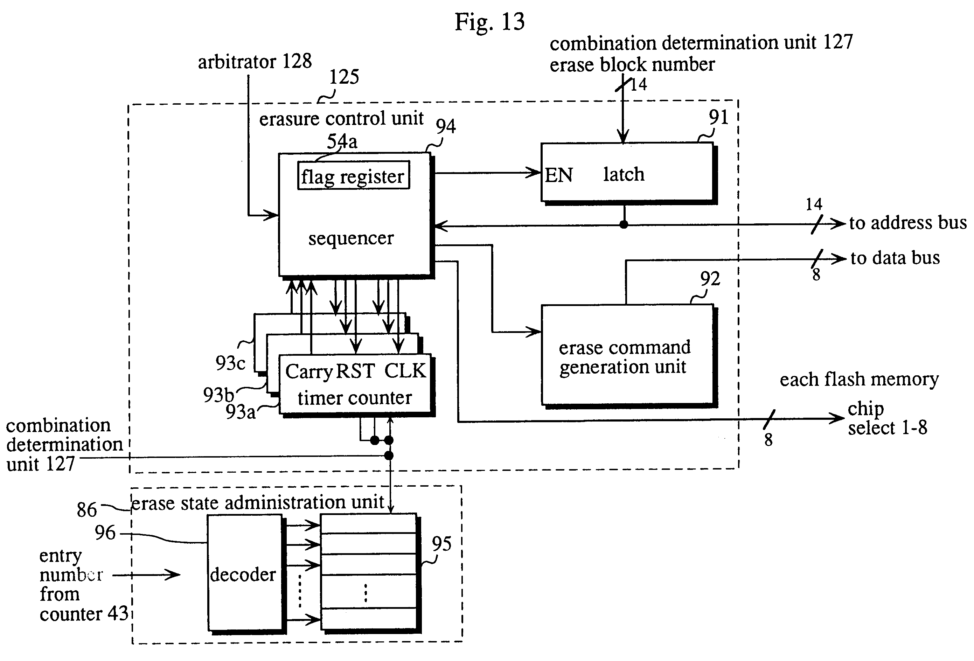

FIG. 13 is a block diagram showing the detailed construction of the erasure control unit 125. The erasure control unit 125 is composed of a latch circuit 51, an erasure command generation unit 52, timer counters 93a-93c, and a sequencer 134, in order to erase three data blocks.

The latch circuit 51 and the erasure command generation unit 52 are equal to their equivalents in the second embodiment, so that they are not described again.

The timer counters 93a-93c are respectively provided to three data blocks, and equal to the timer counter 93 shown in FIG. 9. To be more specific, each of the timer counters 93a-93c stores the count value (erase elapse time) to the corresponding register in the register file 95 when the data erasing operation begins to be suspended, under control of the sequencer 134. Then, the timer counters load the count value from the corresponding register when the data erasing operation is restarted.

The sequencer 134 is different from that shown in FIG. 9 in that three data blocks determined by the combination determination unit 127 are erased concurrently. To be more specific, the sequencer 134 is given the block addresses of the three data blocks (blocks A, B, and C) by the combination determination unit 127. When no suspension request has been issued (or it has been released), the sequencer 134 issues (1) an erasure command (2) a block address to the block A, and starts the counting of the timer counter 93a (starts the count after loading the count value corresponding to block A from the register file 95 to the timer counter 93a. Then, the above mentioned (1) and (2) are carried out by using the timer counters 93b and 93c to the blocks B and C. As a result, the blocks A, B, and C are put in an erasing operation, so that the sequencer 134 is put in an ease time wait state. The erase command issue and the block address issue are about 50nS, which is an negligible time as compared with the erase time 9mS, thus ignoring to start (or to restart) to erase the three data blocks concurrently. After this, when the timer counters 93a-93c output a carry (timeout), a data erasing operation is completed in the same manner as the second embodiment. When an erasure suspension request is sent from the arbitrator 128, the sequencer 134 first issues another command (a readout command or a write command) to the block A in order to suspend the data erasing operation, and writes a count value of the timer counter 93a to the register corresponding to the register file 95. Then the same operations are carried out to the blocks B and C. As a result, a data erasing operation is suspended.

The nonvolatile storage constructed as above of this embodiment operates as follows.

The arbitrator 128 performs the same arbitrating operation as in the second embodiment (FIGS. 10 and 11) when there is a cache hit and a cache miss except in that an erasure suspension request to the erasure control unit 125 is released during a copy back. The common operations are not described again. Since the erasure suspension request is released during a copy back, the erasure control unit 125 erases three data blocks concurrently in step 505 in FIG 10 and step 605 in FIG. 11. However, in steps 507 and 608, the arbitrator 128 directs to erase a data block to be copied back, so that the erasure control unit 125 does not perform concurrent erasure of three data blocks, but erases only one block in the same manner as the second embodiment.

Thus, the data erasing operation for three data blocks and a copy back are carried out concurrently. The data erasing operation and the copy back require 9mS and 3mS respectively. As a result, most of the erase elapse time for each data block to be held in the register file 95 in the erasure control unit 85 can be either 0mS (no erasure or erasure), 3mS, or 6mS. The combination determination unit 37 retrieves the erase state administration unit 86 for the data block selected by the block selection unit 34, thereby determining the combination of the three data blocks. For the combination, 6mS data block has the highest priority, 3mS and OmS data blocks respectively have lower and lowest priorities. If more data blocks whose easing operation has gone as far as 6mS are included in the combination, the data erasing operation can be completed when the copy back operation has been completed. This increases the possibility of ensuring the erased area when the next copy back operation is generated.

As described hereinbefore, according to this embodiment, the secondary storage with high performance can be realized with low power. The secondary storage is realized by erasing a data block in the flash memory chip which is not being accessed while data in a cache entry is written to the flash memory array 1 in a copy back process, making the number of blocks to be erased at the same time be three data blocks and controlling the combination.

Furthermore, according to this embodiment, the power consumption required for data erasing operations and performance can be balanced by controlling the combination of a plurality of blocks to be erased. To be more specific, a data erasing operation is carried out only in a copy back operation, and the maximum number of blocks to be erased concurrently is made three data blocks.

Although the present invention has been fully described by way of examples with reference to the accompanying drawings, it is to be noted that various changes and modifications will be apparent to those skilled in the art. Therefore, unless such changes and modifications depart from the scope of the present invention, they should be construed as being included therein.

## Claims

1. A nonvolatile storage which is accessed in data blocks by a host by using a flash memory composed of a plurality of flash memory chips capable of erasing data in blocks, said nonvolatile storage comprising:
a cache memory having a plurality of cache entries, each of said cache entries including data corresponding to data block in the flash memory and a write bit indicating a presence of a write to a data block in the cache entries;
an erase bit holding means for holding a plurality of erase bits each corresponding to a respective one of the cache entries, said erase bits indicating that data in a data block in the flash memory has bee erased, the data corresponding to the cache entries;
an access target detection means for detecting a flash memory chip to be accessed by the host;
a selection means for selecting a data block in the flash memory, the data block corresponding to the flash memory chips other than the detected flash memory chip, and also corresponding to a data block whose write bit is set and whose erase bit is not set among data blocks which have been entered in the cache memory; and
an erase means for erasing data in more than one data block selected by said selection means and for setting a corresponding erase bit.

2. The nonvolatile storage of claim 1, wherein each of said cache entries includes a block address of a respective data block in the flash memory;
said access target detection means includes an address holding means for holding block addresses to be outputted when the nonvolatile storage is accessed by the host; and
said selection means comprises:
a readout means for serially reading the block addresses and write bits in the cache entries and the erase bits corresponding to the cache entries;
a comparison means for comparing high bits of the block address read by said readout means and high bits of a block address of said address holding means to determine whether the block addresses belong to a same flash memory chip;
an address holding means for holding the block address read by said readout means;
a determination means for, when the block addresses have been determined not belong to the same flash memory chip, making said address holding means hold and output a block address to said erase means, if a write bit read by said readout means is set and an erase bit is not set; and
said erase means erases data in data blocks in accordance with the block address outputted from said address holding means.

3. The nonvolatile storage of claim 2, wherein said erase means comprises:
a timer means for generating a timeout when a predetermined erasing time of data blocks in the flash memory chips has been counted;
a command issue means for issuing an erase command which directs to erase a data block and a block address of data to be erased, to the flash memory chips;
an erasure control means for starting said command issue means to the data block selected by said selection means, making said timer means start a counting operation, and setting an erase bit corresponding to the selected data block when a timeout is generated.

4. The nonvolatile storage of claim 1, wherein said erase means comprises:
a combination determination means for determining a plurality of data block whose data to be erased at a same time, among the data blocks selected by said selection means.

5. The nonvolatile storage of claim 4, wherein said erase means comprises:
a plurality of timer means for generating a timeout when a predetermined erasing time of data blocks in the flash memory chips has been counted;
a command issue means for issuing an erase command which directs to erase a data block and a block address of data to be erased, to the flash memory chips;
an erasure control means for starting said command issue means to the data block selected by said selection means, making one of said timer means start a counting operation, and setting an erase bit corresponding to the selected data block when a timeout is generated; and
said erasure control means starting said plurality of timer means by making each of said plurality of timer means correspond to a data block to be erased.

6. The nonvolatile storage of claim 1 further comprising:
a cache control means for controlling read/write to the cache memory and for exchanging data in the cache memory and data in the flash memory when a cache miss is generated;
an arbitrator means for outputting a suspension request to said erase means when the flash memory chip whose data are to be exchanged is identical to the flash memory chip whose data are being erased by said erase means; and
said erase means suspending a data block erasing operation upon receiving the suspension request and restarting the data block erasing operation when the suspension request has been released.

7. The nonvolatile storage of claim 6, wherein said erase means comprises:
a timer means for generating a timeout when a predetermined erasing time of data blocks in the flash memory chips has been counted;
a command issue means for issuing an erase command which directs to erase a data block and a block address of data to be erased, to the flash memory chips;
a retrieval register having a storage area for retrieving a count value of said timer means;
an erasure control means for starting said command issue means to the data block selected by said selection means, making said timer means start a counting operation, retrieving the count value of said timer means to said retrieval register upon receiving a suspension request from said arbitrator means, and setting an erase bit corresponding to the selected data block when a timeout is generated.

8. The nonvolatile storage of claim 6, wherein said erase means comprises:
a combination determination means for determining a plurality of data block whose data to be erased at a same time, among the data blocks selected by said selection means.

9. The nonvolatile storage of claim 8, wherein said erase means comprises:
a plurality of timer means for generating a timeout when a predetermined erasing time of data blocks in the flash memory chips has been counted;
a command issue means for issuing an erase command which directs to erase a data block and a block address of data to be erased, to the flash memory chips;
a plurality of retrieval registers provided to said plurality of timer means, each having a storage area for retrieving a count value of said timer means;
an erasure control means for starting said command issue means to the data block selected by said selection means, making one of said timer means start a counting operation, retrieving the count value of said timer means to said retrieval register upon receiving a suspension request from said arbitrator means, and setting an erase bit corresponding to the selected data block when a timeout is generated; and
said erasure control means starting said plurality of timer means by making each of said plurality of timer means correspond to a data block to be erased.

10. The nonvolatile storage of claim 9, wherein each of said retrieval registers is provided for a respective entry in the cache memory, and
said erasure control means refers to a retrieval register corresponding to the entry whose data has been determined by said combination determination means, and when a retrieved count value is stored in the retrieval register, returns the count value to a corresponding timer means upon issuing said command, thereby initiating a counting operation.

11. The nonvolatile storage of claim 10, wherein said combination determination means determines a plurality of data blocks by assigning priority to the entry which corresponds to the retrieval register into which a count value has been retrieved.

12. The nonvolatile storage of claim 11, wherein said arbitrator means outputs the suspension request unless a copy back operation is in process for exchanging data of entries by said cache control means.

13. The nonvolatile storage of claim 12, wherein said combination determination means determines a certain number of block, said number is an integer closest to Te/Tcb, said Te indicating said block erase time and said Tcb indicating a time required for copying back data in one block from an entry to said flash memory by said cache control means.

14. A nonvolatile storage which is accessed in data blocks by a host by using a flash memory composed of a plurality of flash memory chips capable of erasing data in blocks, said nonvolatile storage comprising:
a cache memory having a plurality of cache entries, each of said cache entries including data corresponding to data block in the flash memory and a write bit indicating a presence of a write to a data block in the cache entries;
a cache control means for controlling read/write to the cache memory and for exchanging data in the cache memory and data in the flash memory when a cache miss is generated;
an erase bit holding means for holding a plurality of erase bits each corresponding to a respective one of the cache entries, said erase bits indicating that data in a data block in the flash memory has bee erased, the data corresponding to the cache entries;
an access target detection means for detecting a flash memory chip to be accessed by the host;
a selection means for selecting a data block in the flash memory, the data block corresponding to the flash memory chips other than the detected flash memory chip, and also corresponding to a data block whose write bit is set and whose erase bit is not set among data blocks which have been entered in the cache memory;
an erase means for erasing data in more than one data block selected by said selection means and for setting a corresponding erase bit;
an arbitrator means for outputting a suspension request to said erase means when the flash memory chip whose data are to be exchanged is identical to the flash memory chip whose data are being erased by said erase means; and
said erase means suspending a data block erasing operation upon receiving the suspension request and restarting the data block erasing operation when the suspension request has been released.

15. The nonvolatile storage of claim 14, wherein each of said cache entries includes a block address of a respective data block in the flash memory;
said access target detection means includes an address holding means for holding block addresses to be outputted when the nonvolatile storage is accessed by the host; and
said selection means comprises:
a readout means for serially reading the block addresses and write bits in the cache entries and the erase bits corresponding to the cache entries;
a comparison means for comparing high bits of the block address read by said readout means and high bits of a block address of said address holding means to determine whether the block addresses belong to a same flash memory chip;
an address holding means for holding the block address read by said readout means;
a determination means for, when the block addresses have been determined not belong to the same flash memory chip, making said address holding means hold and output a block address to said erase means, if a write bit read by said readout means is set and an erase bit is not set; and
said erase means erases data in data blocks in accordance with the block address outputted from said address holding means.

16. The nonvolatile storage of claim 15, wherein said erase means comprises a combination determination means for determining a plurality of data block whose data to be erased at a same time, among the data blocks selected by said selection means, and wherein said erase means erases a plurality of determined data blocks.

17. The nonvolatile storage of claim 16, wherein said erase means comprises:
a plurality of timer means for generating a timeout when a predetermined erasing time of data blocks in the flash memory chips has been counted;
a command issue means for issuing an erase command which directs to erase a data block and a block address of data to be erased, to the flash memory chips;
a plurality of retrieval registers provided to said plurality of timer means, each having a storage area for retrieving a count value of said timer means;
an erasure control means for starting said command issue means to the data block selected by said selection means, making one of said timer means start a counting operation, retrieving the count value of said timer means to said retrieval register upon receiving a suspension request from said arbitrator means, and setting an erase bit corresponding to the selected data block when a timeout is generated; and
said erasure control means starting said plurality of timer means by making each of said plurality of timer means correspond to a data block to be erased.

18. The nonvolatile storage of claim 17, wherein each of said retrieval registers is provided for a respective entry in the cache memory, and
said erasure control means refers to a retrieval register corresponding to the entry whose data has been determined by said combination determination means, and when a retrieved count value is stored in the retrieval register, returns the count value to a corresponding timer means upon issuing said command, thereby initiating a counting operation.

19. The nonvolatile storage of claim 18, wherein said combination determination means determines a plurality of data blocks by assigning priority to the entry which corresponds to the retrieval register into which a count value has been retrieved.

20. A nonvolatile storage which is accessed in data blocks by a host by using a flash memory composed of a plurality of flash memory chips capable of erasing data in blocks, said nonvolatile storage comprising:
a cache memory having a plurality of cache entries, each of said cache entries including data corresponding to data block in the flash memory and a write bit indicating a presence of a write to a data block in the cache entries;
a cache control means for controlling read/write to the cache memory and for exchanging data in the cache memory and data in the flash memory when a cache miss is generated;
an erase bit holding means for holding a plurality of erase bits each corresponding to a respective one of the cache entries, said erase bits indicating that data in a data block in the flash memory has bee erased, the data corresponding to the cache entries;
an access target detection means for detecting a flash memory chip to be accessed by the host;
a selection means for selecting a data block in the flash memory, the data block corresponding to the flash memory chips other than the detected flash memory chip, and also corresponding to a data block whose write bit is set and whose erase bit is not set among data blocks which have been entered in the cache memory;
a combination determination means for determining a plurality of data blocks to be erased at a same time among the data block selected by said selection means;
an erase means for erasing data in more than one data block selected by said selection means and for setting a corresponding erase bit;
an arbitrator means for outputting a suspension request to said erase means when the flash memory chip whose data are to be exchanged is identical to the flash memory chip whose data are being erased by said erase means; and
said erase means suspending a data block erasing operation upon receiving the suspension request and restarting the data block erasing operation when the suspension request has been released.

21. The nonvolatile storage of claim 20, wherein said arbitrator means outputs the suspension request unless a copy back operation is in process for exchanging data of entries by said cache control means.

22. The nonvolatile storage of claim 21, wherein said combination determination means determines a certain number of block, said number is an integer closest to Te/Tcb, said Te indicating said block erase time and said Tcb indicating a time required for copying back data in one block from an entry to said flash memory by said cache control means.

23. The nonvolatile storage of claim 22, wherein said erase means comprises:
a plurality of timer means for generating a timeout when a predetermined erasing time of data blocks in the flash memory chips has been counted;
a command issue means for issuing an erase command which directs to erase a data block and a block address of data to be erased, to the flash memory chips;
a plurality of retrieval registers provided to said plurality of timer means, each having a storage area for retrieving a count value of said timer means;
an erasure control means for starting said command issue means to the data block selected by said selection means, making one of said timer means start a counting operation, retrieving the count value of said timer means to said retrieval register upon receiving a suspension request from said arbitrator means, and setting an erase bit corresponding to the selected data block when a timeout is generated; and
said erasure control means starting said plurality of timer means by making each of said plurality of timer means correspond to a data block to be erased.

24. The nonvolatile storage of claim 23, wherein each of said retrieval registers is provided for a respective entry in the cache memory, and
said erasure control means refers to a retrieval register corresponding to the entry whose data has been determined by said combination determination means, and when a retrieved count value is stored in the retrieval register, returns the count value to a corresponding timer means upon issuing said command, thereby initiating a counting operation.

25. The nonvolatile storage of claim 24, wherein said combination determination means determines a plurality of data blocks by assigning priority to the entry which corresponds to the retrieval register into which a count value has been retrieved.
